# Europäisches Patentamt

# European Patent Office ·

# Office européen des brevets

(11) Numéro de publication: **0 170 543**
**B1**

(12) **FASCICULE DE BREVET EUROPEEN**

(45) Date de publication du fascicule du brevet:
**14.09.88**

(51) Int. Cl.⁴: **H 05 K  7/14**, H 05 K  7/20

(21) Numéro de dépôt: **85401127.7**

(22) Date de dépôt: **07.06.85**

---

(54) Dispositif d'assemblage mécanique et électrique pour cartes électroniques informatiques à haute intégration.

---

(30) Priorité: **14.06.84  FR 8409308**

(43) Date de publication de la demande:
**05.02.86 Bulletin 86/6**

(45) Mention de la délivrance du brevet:
**14.09.88 Bulletin 88/37**

(84) Etats contractants désignés:
**BE DE GB IT NL SE**

(56) Documents cités:
**EP - A - 0 058 759**
**EP - A - 0 068 195**
**DE - A - 2 757 811**
**FR - A - 2 292 400**
**FR - A - 2 471 059**
**FR - A - 2 477 828**
**US - A - 4 214 292**
**US - A - 4 454 566**

(73) Titulaire: **THOMSON-CSF, 173, Boulevard Haussmann,
F-75379 Paris Cédex 08 (FR)**

(72) Inventeur: **Millot, François, THOMSON-CSF
SCPI 173, bld Haussmann, F-75379 Paris Cedex 08 (FR)**
Inventeur: **Krau, Jean-Claude, THOMSON-CSF
SCPI 173, bld Haussmann, F-75379 Paris Cedex 08 (FR)**

(74) Mandataire: **Lincot, Georges et al, THOMSON-CSF
SCPI 19, avenue de Messine, F-75008 Paris (FR)**

---

ACTORUM AG

## Description

L'invention se rapporte au domaine de la réalisation de systèmes informatiques complexes, et plus particulièrement à un dispositif d'assemblage mécanique et électrique haute densité adapté à l'interconnexion de cartes électroniques à haute intégration, en particulier en environnement sévère.

Des tels dispositifs sont par exemple connus d'après le EP-A-0 068 195.

Les sous-ensembles électroniques et/ou informatiques complexes, ayant une architecture multi-processeurs et multi-bus, et évoluant dans un environnement sévère doivent satisfaire un certain nombre de contraintes: bonne tenue en température, bonne tenur mécanique, et également bonne tenue aux perturbations électromagnétiques.

De plus, pour les systèmes informatiques en technologie 16 ou 32 bits multi-bus, il est nécessaire de prévoir suffisamment de points de connexion sur chacune des cartes; 400 points de connexion est l'ordre de grandeur nécessaire pour ces types de technologies.

Enfin pour minimiser le nombre de cartes, il est intéressant de réaliser des cartes à grande densité d'intégration, et pour cela nécessaire de prévoir l'écoulement des calories dissipées dans les composants.

Il existe actuellement des normalisations pour les formats de cartes électroniques. Cette standardisation permet une intégration et une maintenance aisées, une harmonisation des contraintes pour l'installation des sous-ensembles, une modularité assurant une interchangeabilité entre les divers sous-ensembles, et garantit un bon comportement climatique, mécanique et électrique. A titre d'exemple, le format CEN (cartes électroniques normalisées) en usage dans certains matériels de l'Armement définit des dimensions de cartes de 123 mm × 170 mm. Ce format est suffisamment petit pour que les contraintes mécaniques, tenue aux vibrations, aux secousses ou aux chocs, puissent être tenues. Mais dans la structure classique ce type de cartes ne comporte qu'un connecteur 96 points, éventuellement extensible à 144 ou 200 points mais insuffisant pour répondre aux exigences d'une architecture 16 ou 32 bits multi-bus.

Un autre format utilisé pour les applications civiles, pour un calculateur DLX 32 bits par exemple, est le format dit «double europe» dans lequel les cartes ont des dimensions de 320 mm × 320 mm, et qui comportent chacune quatre connecteurs de 96 points, deux sur chacune de deux arêtes parallèles. Les cartes ayant ce format ne permettent pas de tenir les contraintes d'environnement sévères, par exemple celles imposées pour les systèmes militaires.

Classiquement les connecteurs des cartes électroniques au format CEN sont connectés par l'intermédiaire de connecteurs dits «de fond de panier» placés sur un support, les cartes glissant dans des glissières orthogonales au fond du panier réceptacle. Ainsi les connecteurs de la carte et les connecteurs de fond de panier se font face dès le positionnement de la carte dans la panier. Par ailleurs les connecteurs disposés sur l'arête opposée de la carte, pour les cartes au format double europe, sont connectés par la face avant, l'interconnexion avec l'environnement extérieur étant ainsi effectué par la face avant. L'espacement des points de connexion dans ces connecteurs 96 points est 2,54 mm, l'espacement normalisé des cartes dans le panier étant soit 12,7 mm soit 7,62 mm. L'évacuation des calories est généralement prévue dans le cadre formant l'ossature mécanique de la carte, dont la forme est adaptée à la dissipation nécessaire.

Ces structures connues ne permettent pas de résoudre le problème indiqué ci-dessus. En particulier elles ne sont pas utilisables en technologie 32 bits avec au moins 400 points de connexion en tenant compte de contraintes d'environnement sévères et en offrant une haute densité d'intégration.

L'invention a pour objet un dispositif d'assemblage mécanique et électrique pour cartes électroniques informatiques à haute intégration qui permette de résoudre ces problèmes. Elle met en œuvre à cette fin des connecteurs à haute densité, par exemple 200 points, à force d'insertion nulle, associés à des moyens de verrouillage et à un réceptacle particulier.

Suivant l'invention un dispositif d'assemblage mécanique et électrique pour cartes électroniques informatiques à haute intégration comporte un réceptacle dans les parois latérales duquel sont prévues des évidements recevant chacun au moins un connecteur multicontacts, dont les contacts sont répartis le long de la fente d'insertion de carte dans le connecteur, ce connecteur ayant une force d'insertion nulle et étant associé à un dispositif de verrouillage-déverrouillage, ce réceptacle étant destiné au raccordement de cartes électroniques ayant des pistes de contacts espacées comme les contacts des connecteurs, sur au moins une face de la carte et sur deux côtés opposés ce dispositif étant caractérisé en ce que le réceptacle est du type monobloc profilé en forme de U, qu'au moins une fente est prevue dans le fond du réceptacle et que le réceptacle comporte un connecteur thermique placé dans la fente correspondante dans le fond du réceptacle, le fond du réceptacle formant dosseret échangeur thermique.

L'invention sera mieux comprise et d'autres caractéristiques apparaîtront à l'aide de la description qui suit en référence aux figures annexées.

La figure 1 est un schéma synoptique d'un système multi-processeurs et multi-bus auquel s'applique, à titre d'exemple, le dispositif d'assemblage suivant l'invention.

La figure 2 est le schéma d'un réceptacle élémentaire d'un dispositif d'assemblage suivant l'invention.

La figure 3 est le schéma d'un dispositif d'assemblage multicartes suivant l'invention.

La figure 4 est le schéma d'une carte adaptée au dispositif d'assemblage suivant l'invention.

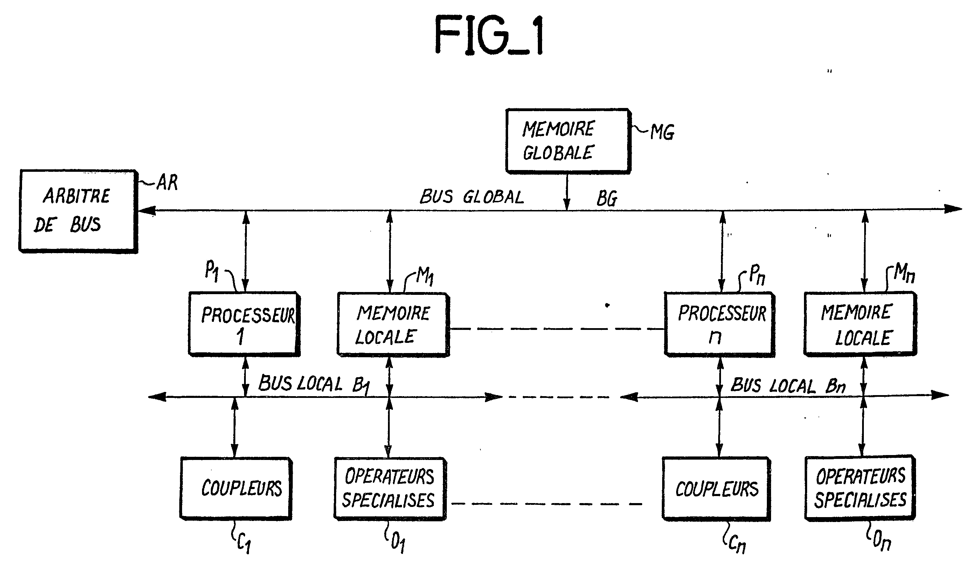

Sur la figure 1, on a représenté un système multi-processeurs et multi-bus permettant de bien comprendre l'intérêt du dispositif d'assemblage suivant l'invention. Ce système comporte des processeurs 16 ou 32 bits, $P_1$...$P_n$ auxquels sont associées des mémoires locales $M_1$...$M_n$. Un certain nombre de coupleurs $C_1$...$C_n$ sont associés respectivement à chacun des processeurs $P_1$...$P_n$, ainsi que des opérateurs spécialisés $O_1$...$O_n$. Dans un sous-ensemble, d'indice i, i=1 à n, le processeur $P_i$, la mémoire $M_i$, les coupleurs $C_i$, et les opérateurs spécialisés $O_i$ sont interconnectés par l'intermédiaire d'un bus local $B_i$. Par ailleurs ces sous-ensembles sont interconnectés entre eux par l'intermédiaire d'un bus global BG, I associé à une mémoire globale MG; un circuit d'arbitrage de bus, AR, est prévue pour régir les échanges entre les sous-ensembles. Dans un tel système avec des micro-processeurs 32 bits, le bus global avec les connexions d'alimentation doit comporter environ 200 points; chaque unité centrale de processeur ou mémoire locale est reliée au bus global par 100 points environ. De même les sorties des processeurs, mémoires locales, coupleurs, ou opérateurs spécialisés se font également par des ensembles de 100 points, comme les entrées sorties. En conséquence, il est intéressant de prévoir des systèmes d'assemblage adaptés, permettant l'intégration éventuelle de plusieurs fonctions sur une même carte avec une haute densité d'intégration, le système d'assemblage comportant de l'ordre de 400 points de connexion pour relier une carte au bus global d'un système ainsi qu'aux bus locaux de différents sous-ensembles.

Le dispositif d'assemblage mécanique et électrique suivant l'invention est constitué d'un réceptacle auquel sont associés des cartes mères avec des moyens de protection éventuels adapté à l'interconnexion d'éléments électroniques enfichables, ou cartes, dont les points de contact et connecteurs thermiques sont organisés d'une manière particulière, comme il sera décrit ci-après.

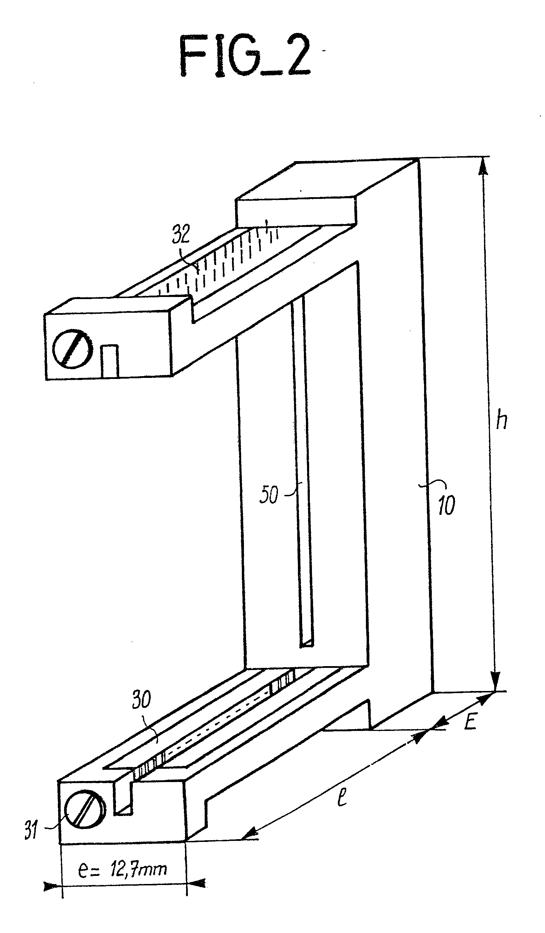

Un réceptable élémentaire du dispositif d'assemblage électrique suivant l'invention est représenté sur la figure 2. Ce réceptacle 10 est destiné à recevoir, maintenir et interconnecter, un élément électronique enfichable, au moyen de deux connecteurs à force d'insertion nulle. Ce réceptable 10 est constitué d'un profilé métallique en forme de U, dont les dimensions, longueur des branches l, hauteur du fond h et largeur e sont adaptés à la norme utilisée. Ce réceptacle est réalisé en alliage léger, AG4 par exemple, par des techniques de moulage du type au sable, en coquilles, à la cire perdue, ou par injection. Chaque branche du U comporte un évidement rectangulaire, recevant un connecteur 30, à 200 contacts et à force d'insertion nulle. La fente du connecteur est prolongée jusqu'aux extrémités des branches du U de façon que l'insertion de l'élément électronique enfichable soit faite par glissement dans les fentes, parallèlement aux branches. Une fente 50 est également prévue dans le fond du réceptacle, et est destinée à recevoir un connecteur thermique prévu dans l'élément électronique enfichable. L'épaisseur E du fond du U est suffisante pour que ce réceptacle assure la fonction de dosseret thermique. Dans le format compatible d'une intégration mécanique en coffret 1/2 ATR, les dimensions des cartes sont 123 mm×193 mm. Dans le format compatible d'une intégration mécanique en coffret 3/4 ATR les dimensions des cartes sont 190 mm × 193 mm. La largeur utile au niveau des contacts, prise dans la dimension commune à ces deux formats, 193 mm, est de l'ordre de 140 mm. Dans un mode de réalisation de l'invention les connecteurs à force d'insertion nulle comportent donc 100 contacts de chaque côté du connecteur, espacés de 1,27 mm, face à face ou alternés. Sur l'autre face du connecteur, les terminaisons 32, orthogonales au connecteur sont alternées au pas de 1,27 mm. Ces terminaisons sont étamées et du type à souder sur circuit imprimé.

Les connecteurs à force d'insertion nulle 30 comportent chacun 200 contacts comme indiqué ci-dessus, à un espacement de 1,27 mm, et fonctionnent de la manière suivante: chaque connecteur a deux positions pour les contacts et est commandé par un dispositif de verouillage-déverrouillage 31. Lors de l'insertion de l'élément électronique enfichable dans les fentes du réceptable et du connecteur, le connecteur est en position ouverte, ses contacts étant effacés dans des fentes du connecteur et, aucun effort n'est appliqué sur la piste de contacts de l'élément électronique enfichable. Lorsque cet élément est correctement positionné, le dispositif de verrouillage-déverrouillage 31 permet en sortant les contacts de leurs logements de les appliquer sur les pistes correspondantes des fichiers de la carte, également au pas de 1,27 mm. Les contacts sont alors verrouillés dans cette position. Le passage de la position ouverte à la position fermée s'effectue par un système de verrouillage-déverrouillage 31 accessible à l'extrémité de chaque branche du réceptacle par un outillage approprié.

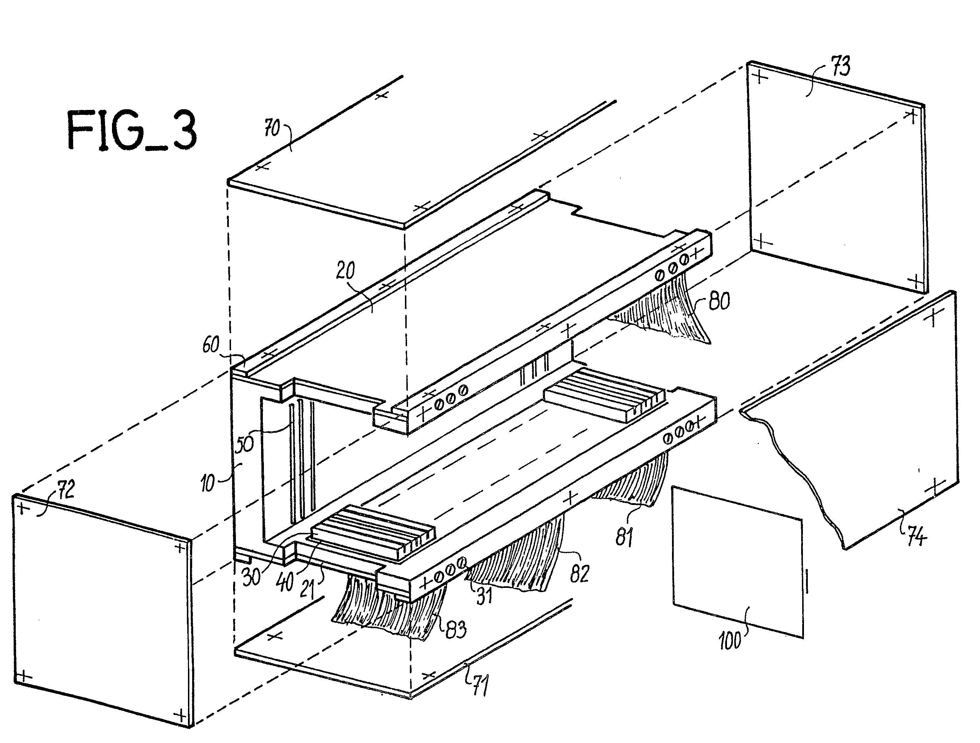

La figure 3 représente le système de dispositif d'assemblage suivant l'invention, avec un réceptacle multicartes. Sur cette figure les mêmes éléments que sur la figure 2 ont été désignés par les mêmes repères. Le réceptacle 10 est destiné à recevoir, maintenir, et interconnecter, un ensemble d'éléments électroniques enfichables ou cartes électroniques a l'aide de connecteurs à force d'insertion nulle. Le réceptacle lui-même est constitué d'un profilé métallique dont la section est en forme de U et dont la longueur est prévue pour recevoir un certain nombre de cartes. Chaque paroi latérale associée à une branche du U est destinée à recevoir des connecteurs à 200 contacts à force d'insertion nulle, et, comme décrit précédemment, le fond du U est réservé à l'évacuation thermique. Les parois correspondant aux branches du U profilé sont évidées pour recevoir chacune un ensemble de connecteurs. Ces connecteurs peuvent être interconnectés au moyen d'un circuit de câblage pour chaque paroi latérale, par exemple une carte mère, 20 et 21 respectivement, préalablement soudées à la vague à ces connecteurs. Ces cartes mères 20 et 21 sont des circuits imprimés permettant de réaliser directement les interconnexions entre cartes disposées dans un même réceptacle multicartes. Dans un mode de réalisation préféré de l'invention, l'espacement entre les cartes prévu étant l'espacement normalisé 12,7 mm et la largeur des connecteurs étant également voisine de 12,7 mm, l'évidement 40 du réceptacle pour le positionnement des connecteurs soudés à la carte mère 20 ou 21 est réalisé en une seule fois sur toute la longueur du réceptacle, ceci pour éviter de superposer plusieurs tolérances quant au positionnement. Dans le mode de réalisation représenté, les connecteurs 30 dépassent du réceptacle, et leur fente d'insertion est donc accessible à l'intérieur du U, sans avoir à ménager de fente dans le réceptacle 10. Le fond du profilé métallique 10 formant réceptacle comporte des fentes 50 espacées de 12,7 mm, dans lesquelles peuvent être insérés des connecteurs thermiques prévus sur l'une des arêtes des cartes électroniques. Des barres de renfort d'alimentation 60 peuvent être prévues et soudées sur la face de la carte mere opposée à celle portant les connecteurs, et sur toute la longueur du profilé. Le réceptacle est muni d'un dispositif de verrouillage-déverrouillage 31 formé d'un élément de verrouillage-déverrouillage associé à chaque connecteur 30, et disposés le long du receptacle.

Ce réceptacle 10 qui forme l'ossature du dispositif d'assemblage selon l'invention peut être complété par un habillage qui permet de protéger les cartes mères ainsi que les cartes filles enfichées dans le réceptacle. Pour cela des capots métalliques de protection 70 et 71 sont prévus pour les deux cartes mères portant les connecteurs. Ils sont fixés au réceptacle 10 par l'intermédiaire des barres de renfort 60 et des bords des cartes mères. Ces capots peuvent être rendus hermétiques. Les extrémités du profilé réceptacle en forme de U peuvent être fermées dans le cas d'une utilisation en baie par des flasques, ou dans le cas d'une utilisation directe par des panneaux, 72 et 73 sur la figure 3 par exemple, l'un étant éventuellement muni d'un pupitre opérationnel appliqué à l'une des extrémités et l'autre portant les prises d'interconnexion extérieures à l'autre extrémité.

La face du réceptacle laissée libre pour l'introduction des cartes est fermée par une plaque 74 prenant appui sur des dosserets prévus sut le quatrième côté des cartes pour assurer une conduction thermique supplémentaire vers l'extérieur.

Une telle structure permet de prévoir que toutes les liaisons d'alimentation et de bus global seront prévues sur l'une des parois latérales du réceptacle en forme de U, la sortie bus global étant assurée par exemple dans un tel dispositif de raccordement au moyen d'un connecteur à haute densité de la carte mère supérieure réservé à cet effet, dans lequel aucune carte électronique n'est enfichée et auquel est reliée une limande blindée 80. De même, sur la face opposée, le raccordement entre les différents connecteurs est réalisé directement via la carte mère 21 en circuit imprimé pour l'interconnexion entre cartes portées par un même réceptacle. Des limandes blindées 81, 82, 83 par exemple peuvent être prévues et raccordées à certains des connecteurs à haute densité pour réaliser les connexions d'entrée/sortie.

Du fait de la structure du réceptacle, et du fait que la dissipation des calories est assurée par un connecteur thermique relié au fond du U, plusieurs modes de refroidissement peuvent être utilisés: Le dosseret du réceptacle, c'est-à-dire le fond du U, recevant les connecteurs thermiques des cartes est le radiateur thermique naturel dans cette technologie. Les échanges thermiques peuvent s'effectuer à ce niveau soit par convection naturelle, soit par conduction (le dosseret du réceptacle étant fixé sur un échangeur thermique, ou un caléoduc, ou un échangeur à effet pelletier etc. . . .), soit par convection forcée, le dosseret pouvant être ouvragé pour permettre le passage d'une ventilation forcée. Le carte mère supérieure, associée au bus global peut permettre également comme indiqué ci-dessus de distribuer l'alimentation sur les connecteurs de la partie supérieure. Cette carte mère bus global, peut être réalisée par circuit imprimé multicouches. Le raccordement éventuel de ce bus vers l'extérieur est prévu par des trous métallisés en bout de cartes permettant le raccordement d'une nappe imprimée. La carte mère bus locaux est adaptée à chaque application.

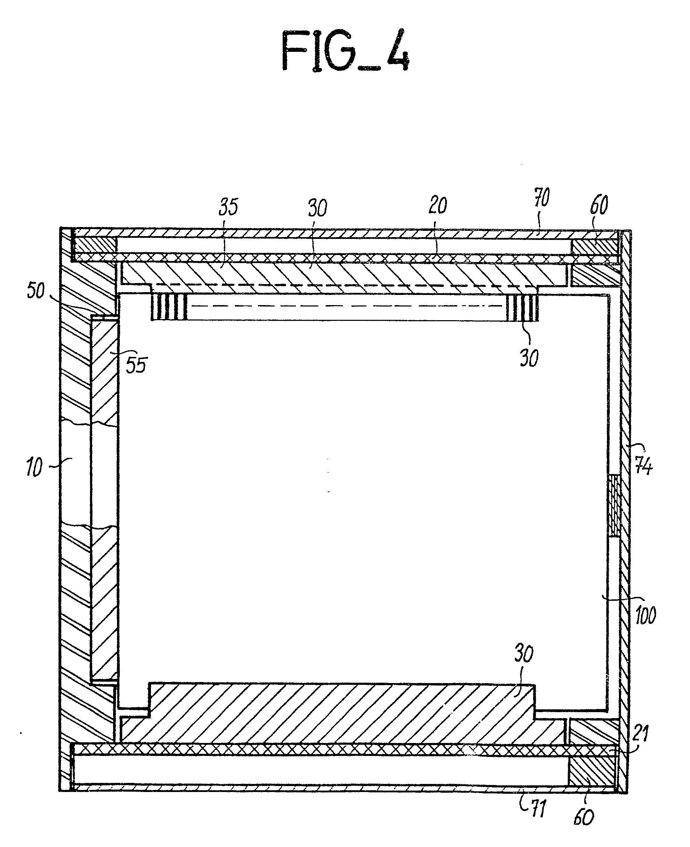

La figure 4 représente en coupe le dispositif d'assemblage mécanique électrique suivant l'invention dans lequel à été insérée une carte électronique. La carte 100 comporte une zone utile centrale, un connecteur thermique 55 pour insertion dans une fente 50 du dosseret du réceptacle, deux fichiers de 200 points chacun implantés dans deux zones de la carte 35 situées sur deux côtés opposés et constituant la zone de guidage: les pistes de connexion sont déposées par photogravure, au pas de 1,27 mm. Les deux parois latérales du dispositif sont symétriques mais on a représenté dans le haut de la figure 4 la partie connecteur 30 et dans le bas de la figure la partie carte avec ses pistes de contact dans la zone 35.

Un dosseret supplémentaire est disposé sur le quatrième côté de la carte. Comme indiqué ci-dessus, en format compatible d'une intégration mécanique en coffret 1/2 ATR les dimensions hors tout de la carte peuvent être 80 mm × 190 mm. Ce format de carte permet l'implantation par face de 30 boîtiers conventionnels 14 ou 16 broches, ou 60 boîtiers de type «chip carrier», ou encore 100 à 120 puces hybridées. En format compatible d'une intégration mécanique en coffret 3/4 ATR c'est-à-dire 145×190 mm, une telle carte permet l'implantation par face de 60 boîtiers convertionnels 14 ou 16 broches, ou 120 boîtiers de type «chip carrier.» Ce format permet également l'implantation de puces hybridées au moyen de supports adaptés Les puissances dissipées envisagées peuvent être de l'ordre de 20 watts pour un substrat céramique, 15 watts pour un substrat colaminé, ou 10 watts pour un substrat en verre époxy.

L'invention n'est pas limitée aux modes de réalisation décrits et représentés. En particulier, la valeur indiquée pour le pas des connecteurs, 1,27 mm, a été choisie moitié du pas habituel 2,54 mm. Mais cette valeur n'est pas limitative et des valeurs voisines permettant de conserver le même ordre de grandeur pour le nombre de points de connexion pourraient également être choisies. De même le nombre de points de connexion, 400, n'est pas limitatif. Il a été indiqué pour permettre de garder quelques points de connexion supplémentaires en plus des points nécessaires dans un système 32 bits. De plus les connecteurs décrits, ayant des contacts de chaque côté de la fente d'insertion sont adaptés aux cartes double face. Mais des connecteurs adaptés à des cartes simple face, comportant des contacts d'un seul côté de la fente d'insertion peuvent également être utilisés.

D'autre part, le connecteur thermique peut également être utilisé pour augmenter, au delà de 400 points, la capacité de raccordement d'une carte électronique (par exemple bus alimentation, masses électriques et mécaniques etc. . .).

Par ailleurs, le dispositif d'assemblage mécanique et électrique a été décrit ci-dessus comme comportant autant de connecteurs que peut en contenir l'évidement prévu dans les parois latérales du réceptacle. En pratique, cette configuration peut être adaptée à la configuration de l'application, et certains des connecteurs prévus à l'espacement élémentaire peuvent être supprimés, par exemple lorsqu'un sous-ensemble est câblé en double épaisseur et occupe deux espaces élémentaires. Il serait aussi possible pour bien maintenir mécaniquement un sous-ensemble comportant deux cartes de prévoir un connecteur dans lequel les contacts électriques ne seraient pas utilisés.

Le dispositif d'assemblage mécanique et électrique suivant l'invention, qui assure simultanément la tenue mécanique et les connexions électriques, est particulièrement bien adaptable, du fait de la possibilité de séparation physique du câblage entre le bus global et les bus locaux, et du fait des larges possibilités d'extension par la banalisation du câblage.

Ce dispositif d'assemblage peut accueillir tous les types de cartes simple ou double face: cartes classiques avec des composants standards, cartes «Chip carrier», carte de circuits hybrides, ou cartes utilisant des composants issus de technologies différentes.

**Revendications**

1. Dispositif d'assemblage mécanique et électrique pour cartes électroniques informatiques à haute intégration, comportant un réceptacle (10) dans les parois latérales duquel sont prévues des évidements recevant chacun au moins un connecteur multicontacts (30) dont les contacts sont répartis le long de la fente d'insertion de carte dans le connecteur, ce connecteur ayant une force d'insertion nulle et étant associé à un dispositif de verrouillage-déverrouillage (31), ce réceptacle étant destiné au raccordement de cartes électroniques ayant des pistes de contacts espacées comme les contacts des connecteurs sur au moins une face de la carte et sur deux côtés opposés caractérisé en ce que le réceptacle est du type monobloc profilé en forme de U, qu'au moins une fente (50) est prevue dans le fond du réceptacle et que le réceptacle comporte un connecteur thermique placé dans la fente (50) correspondante dans le fond du réceptacle, le fond du réceptacle (10) formant dosseret échangeur thermique.

2. Dispositif selon la revendication 1, caractérisé en ce que les connecteurs sont des connecteurs à 200 points de contact ayant 100 points de chaque côté de la fente d'insertion de carte, les dits points de contact étant espacés de 1,27 mm.

3. Dispositif selon l'une des revendications 1 et 2, caractérisé en ce que un circuit de câblage (20, 21) auquel sont directement soudées les terminaisons externes des connecteurs correspondants est rapporté sur les parois latérales externes du réceptacle (10).

4. Dispositif selon la revendication 3, caractérisé en ce que les circuits de câblage sont des cartes mères (20, 21) portant en circuit imprimé les liaisons entre connecteurs fixés à une même paroi latérale du réceptacle.

5. Dispositif selon la revendication 4, caractérisé en ce qu'un habillage amovible (70, 71) est prévu pour protéger les cartes mères (20, 21) tout en laissant accessibles ces cartes pour d'éventuels tests.

6. Dispositif selon la revendication 5, caractérisé en ce que des barres de renfort d'alimentation (60) sont placées sur les quatre arêtes du profilé entre la carte mère et l'habillage constitué de deux plaques de protection (70, 71), chacune rapportée sur une carte mère (20, 21) via les barres de renfort.

7. Dispositif selon l'une des revendications précédentes pour des cartes comportant sur le côté opposé au connecteur thermique un deuxième dosseret d'échange thermique, caractérisé en ce qu'il comporte en outre une plaque (74) fermant le U et susceptible de s'appuyer sur les deuxièmes dosserets des cartes pour assurer également une conduction thermique vers l'extérieur.

8. Dispositif selon la revendication 1, caractérisé en ce que le connecteur thermique disposé dans la fente comporte également des contacts électriques pour augmenter la capacité de raccordement d'une carte électronique.

**Patentansprüche**

1. Vorrichtung zum elektrischen und mechanischen Zusammenbauen für hochintegrierte elektronische Schaltungskarten mit einem Gehäuse, in dessen Seitenwänden Aussparungen vorgesehen sind, die jeweils wenigstens einen Vielkontakt-Verbinder (30) aufnehmen, dessen Kontakte entlang des Einsteckschlitzes der Karte in dem Verbinder verteilt sind, wobei dieser Verbinder eine verschwindende Einsteckkraft hat und einer Verriegelungs-Entriegelungseinrichtung (31) zugeordnet ist, wobei dieses Aufnahmegehäuse für den Anschluss elektronischer Schaltungskarten bestimmt ist, welche auseinanderliegende Kontaktbahnen wie diejenigen der Verbinder auf wenigstens einer Fläche der Schaltungskarte und auf zwei entgegengesetzten Seiten aufweist, dadurch gekennzeichnet, dass das Aufnahmegehäuse vom Typ Monoblock mit U-Profil ist, wenigstens ein Schlitz (50) am Boden des Aufnahmegehäuses vorgesehen ist und dass das Aufnahmegehäuse einen thermischen Verbinder umfasst, der in dem entsprechenden Schlitz (50) am Boden des Gehäuses angebracht ist, wobei der Boden des Gehäuses (10) eine Wärmetauscher-Rückwand bildet.

2. Vorrichtung nach Anspruch 1, dadurch gekennzeichnet, dass die Verbinder 200 Kontaktstellen aufweisen, mit 100 Stellen auf jeder Seite des Karteneinsteckschlitzes, wobei die genannten Kontaktstellen um 1,27 mm auseinanderliegen.

3. Vorrichtung nach einem der Ansprüche 1 oder 2, dadurch gekennzeichnet, dass ein Verdrahtungskreis (20, 21), an welchem die äusseren Enden der entsprechenden Verbinder unmittelbar angelötet sind, auf die äusseren Seitenwände des Gehäuses (10) aufgesetzt ist.

4. Vorrichtung nach Anspruch 3, dadurch gekennzeichnet, dass die Verdrahtungskreise Mutterkarten (20, 21) sind, welche die Verbindungen zwischen den auf einer selben Seitenwand des Gehäuses befestigten Verbindern auf einer gedruckten Schaltung tragen.

5. Vorrichtung nach Anspruch 4, dadurch gekennzeichnet, dass eine abnehmbare Verkleidung (70, 71) zum Schutz der Mutterkarten (20, 21) vorgesehen ist, wobei diese Karten für eventuelle Tests zugänglich bleiben.

6. Vorrichtung nach Anspruch 5, dadurch gekennzeichnet, dass Stromversorgungs-Verstärkungsstäbe (60) auf den vier Kanten des Profils zwischen der Mutterkarte und der Ummantelung angeordnet sind, welche aus zwei Schutzplatten (70, 71) besteht, wobei jede dieser Platten auf einer Mutterkarte (20, 21) über die Verstärkungsstäbe angebracht wird.

7. Vorrichtung nach einem der vorstehenden Ansprüche für Karten, die auf der dem thermischen Verbinder entgegengesetzten Seite eine zweite Wärmetauscher-Rückwand aufweisen, dadurch gekennzeichnet, dass sie ferner eine das U abschliessende Platte umfasst, die sich auf der zweiten Rückwand der Karten abstützen kann, um ebenfalls eine Wärmeleitung nach Aussen zu gewährleisten.

8. Vorrichtung nach Anspruch 1, dadurch gekennzeichnet, dass der in dem Schlitz angeordnete thermische Verbinder ebenfalls elektrische Kontakte umfasst, um die Verbindungskapazität einer elektronischen Schaltungskarte zu erhöhen.

## Claims

1. A mechanical and electrical assembly for high integration electronic information boards, comprising an enclosure in the lateral walls of which hollows are provided of which each receives at least one multicontact connector (30), whose contacts are spaced out along the length of the groove for insertion of the board into the connector, such connector having a zero insertion force and being associated with a locking and unlocking device (31), such enclosure being adapted for the connection of: electronic boards having contact strips spaced like the contacts of the connectors on at least one surface of the board and on two opposite sides, characterized in that the enclosure is of the monoblock type with the profile of a U, in that at least one groove (50) is provided in the bottom of the enclosure and in that the enclosure comprises a thermal switch placed in the corresponding groove (50) in the bottom of the enclosure, the bottom of the enclosure (10) forming a thermal exchange sink.

2. The device as claimed in claim 1, characterized in that the connectors are 200 contact pin connectors having 100 pins on each side of the receiving groove of the board, the said contact pins being spaced by 1.27 mm.

3. The device as claimed in claim 1 or claim 2, characterized in that a wiring circuit (20 and 21) to which the external terminations of the corresponding connectors are directly soldered is arranged on the lateral external walls of the enclosure (10).

4. The device as claimed in claim 3, characterized in that the wiring circuits are mother boards (20 and 21) carrying, in the form of a printed circuit, the connections between the connectors fixed to a single lateral wall of the enclosure.

5. The device as claimed in claim 4, characterized in that a fixed casing (70 and 71) is provided in order to protect the mother boards (20 and 21) while leaving access to these boards for any testing.

6. The device as claimed in claim 5, characterized in that feed reinforcement bars (60) are placed at the four corners of the section between the mother board and the casing constituted by two protective plates (70 and 71), each arranged on a mother board (20 and 21) via the reinforcing bars.

7. The device as claimed any one of the preceding claims for boards having, on the side opposite to the thermal connector, a second thermal exchange sink, characterized in that it furthermore comprises a plate (74) closing the U and adapted to rest against the second sinks of these boards in order also to ensure thermal conduction to the exterior.

8. The device as claimed in claim 1, characterized in that the thermal connector arranged in the groove also comprises electrical contacts in order to increase the connection capacity of an electronic board.

# FIG_1

ARBITRE DE BUS — AR

MEMOIRE GLOBALE — MG

BUS GLOBAL         BG

PROCESSEUR 1 — $P_1$

MEMOIRE LOCALE — $M_1$

PROCESSEUR n — $P_n$

MEMOIRE LOCALE — $M_n$

BUS LOCAL $B_1$

BUS LOCAL $B_n$

COUPLEURS — $C_1$

OPERATEURS SPECIALISES — $O_1$

COUPLEURS — $C_n$

OPERATEURS SPECIALISES — $O_n$

# FIG_2

32

31

30

50

10

h

E

ℓ

e = 12,7mm

FIG_3

0 170 543

# FIG_4